# EUROPÄISCHE PATENTSCHRIFT

(11) **EP 1 800 349 B1**
(45) Veröffentlichungstag und Bekanntmachung des Hinweises auf die Patenterteilung: **29.07.2015**
(21) Anmeldenummer: 05784623.0
(22) Anmeldetag: 12.09.2005
(51) Int. Cl.: G01K 7/22, H01L 27/08, H01L 49/02, H01L 29/8605, H01L 21/329

(54) **NTC-HALBLEITERWIDERSTAND**
NTC SEMICONDUCTOR RESISTANCE
RESISTANCE SEMI-CONDUCTRICE À COEFFICIENT DE TEMPERATURE NEGATIF

(30) Priorität: 06.10.2004 DE 102004048607
(43) Veröffentlichungstag der Anmeldung: 27.06.2007
(73) Patentinhaber: ROBERT BOSCH GMBH, 70442 Stuttgart (DE)
(72) Erfinder: FLOHRS, Peter, 72770 Reutlingen (DE); GOERLACH, Alfred, 72127 Kusterdingen (DE); URBACH, Peter, 72762 Reutlingen (DE); FEILER, Wolfgang, 72766 Reutlingen (DE); QU, Ning, 72770 Reutlingen (DE); HEYERS, Klaus, 72766 Reutlingen (DE)
(86) Internationale Anmeldenummer: PCT/EP2005/054523
(87) Internationale Veröffentlichungsnummer: WO 2006/037711

(56) Entgegenhaltungen:
- US-A- 3 171 068
- US-A- 3 729 662
- US-A- 4 035 757
- US-A- 4 065 742
- US-A- 4 670 731
- US-A1- 2001 022 385
- US-A1- 2004 070 050

## Beschreibung

Die Erfindung betrifft ein Halbleiterbauelement mit den Merkmalen des Anspruchs 1, insbesondere einen temperaturabhängigen Halbleiterschalter mit temperaturabhängigem Widerstand, der zur Strombegrenzung eingesetzt werden kann, sowiese ein Verfahren dessen Herstellung.

### Stand der Technik

Bei vielen elektrotechnischen Anwendungen ist es erforderlich, den in einem Schaltkreis fließenden elektrischen Strom auf einen Maximalwert zu begrenzen. Besonders sogenannte Einschaltspitzen des Stroms, die hauptsächlich beim Einschalten von induktiven Verbrauchern entstehen, müssen üblicherweise auf Maximalwerte begrenzt werden. Dies gilt besonders in Kraftfahrzeugbordnetzen, bei denen beispielsweise der Starter eine sehr niederohmige Last mit hoher Induktivität darstellt, die beim Einschalten beim Beginn des Startvorgangs zu einer Stromspitze und damit zu einem Spannungseinbruch im Bordnetz führt. Wenn die Stromspitze begrenzt werden kann, wird auch der Spannungseinbruch im Bordnetz geringer ausfallen. Nach dem Ende der Stromspitze, beim Betätigen eines Starters in einem Fahrzeug also etwa nach hundert Millisekunden, sollte die Strombegrenzung möglichst nicht mehr wirksam sein, damit der dann fließende Strom nicht unnötig verringert wird.

Die Begrenzung hoher Stromspitzen lässt sich beispielsweise durch den Einsatz von Leistungselektronikbauteilen realisieren. Auch gibt es Vorschläge, bei denen zur Strombegrenzung ein NTC-Widerstand, also ein Widerstand mit negativem Temperaturkoeffizienten in der Zuleitung zum Verbraucher, beispielsweise in der Versorgungsleitung für den Starter eingesetzt wird. Ein solcher NTC-Widerstand begrenzt die beim Einschaltvorgang auftretende Stromspitze, da der Widerstand des kalten Bauteils relativ hoch ist. Bei Erwärmung des NTC-Widerstands durch die bei fließendem Strom in ihm umgesetzte elektrische Leistung nimmt der Wert des NTC-Widerstandes ab und reduziert dann den Strom durch den Verbraucher nur noch wenig. In der DE 41 22 252 A1 wird eine solche Strombegrenzung für einen Starter in einem Fahrzeug beschrieben, bei der der negative Temperaturkoeffizient des Widerstandes ausgenutzt wird, um im kalten Zustand die Stromspitze zu dämpfen und im erwärmten Zustand den Strom gut zu leiten.

In der nicht vorveröffentlichten internationalen Patentanmeldung DE 2004/00 07 76 wird vorgeschlagen, in die Starterleitung einen Widerstand einzubauen, der als Siliziumwiderstand mit schwach dotiertem Silizium ausgestaltet ist. Dieser Widerstand ändert seinen Wert bei höheren Temperaturen durch Erreichen der Eigenleitung, wobei dies zu einer deutlichen Verringerung des Widerstandswertes führt. Mit einem derartigen Widerstand in der Starterleitung wird sichergestellt, dass bei kaltem Widerstand der Starterstrom begrenzt wird und so die beim Einschalten des Starters auftretende Stromspitze gedämpft wird, während nach Erwärmung des Widerstandes in Folge des durch ihn fließenden Stromes der Widerstandswert verringert wird und so der fließende Strom nur noch wenig abgesenkt wird.

Temperaturabhängige Widerstände aus Silizium mit mit negativem Temperaturkoeffizienten (NTC-Widerstände) haben den Nachteil, dass bei den eingesetzten Dotierungen im Bereich von 10¹⁴ pro cm² erst bei Temperaturen um 300° Celsius merklich niedrigere Widerstandswerte als bei Raumtemperatur zu beobachten sind. Das periodische Anfahren solcher Temperaturen stellt aber sehr hohe Anforderungen an die Aufbau- und Verbindungstechnik. Bei deutlich schwächerer Dotierung des Siliziums wird die zur Darstellung eines bestimmten Wertes des Widerstandes benötigte Fläche sehr groß und/oder die Schichtdicke sehr klein.

Aus der US 4,035,757 ist ein Halbleiterbauelement bekannt, das als lateraler Widerstand ausgestaltet ist. Es umfasst ein hochdotiertes p-Gebiet, ein niedrigdotiertes p-Gebiet und noch ein hochdotiertes p-Gebiet. Zusätzlich ist ein n-Gebiet vorhanden, das einen pn-Übergang bildet. Eine Seite des pn-Übergangs ist durch einen Leiter kurzgeschlossen.

Aus der US 4,670,731 ist ein Temperatursensor, der als Halbleiterbauelement aufgebaut ist, bekannt. Durch geeignete Maßnahmen wird die Temperaturabhängigkeit in vorgebbarer Weise eingestellt. Als Halbleitermaterial wird Silizium verwendet, das beispielsweise antimon- oder arsendotiert ist und damit n-leitend ist. Ein weiterer n-leitender Bereich besteht aus phosphordotiertem Silizium.

Aus der US 4,065,742 ist ein elektronisches Halbleiterbauelement bekannt, das im wesentlichen ein monokristallines Siliziumteil umfasst, in das Gräben geätzt sind. Diese Gräben richten sich an der Kristallorientierung des Siliziums aus. In die Gräben ist anders dotiertes Material eingebracht.

### Vorteile der Erfindung

Das erfindungsgemäße Halbleiterbauteil mit den Merkmalen des Anspruchs 1 hat demgegenüber den Vorteil, dass die Temperatur, bei der der Wert des Widerstandes abnimmt in weiten Bereichen beliebig verändert und damit auch verringert werden kann, wobei dies auch bedeutet, dass der Widerstandswert bei einer bestimmten Temperatur variabel gestaltet werden kann. Erzielt wird dieser Vorteil, indem durch den Einbau von p-dotierten Inseln in das n-leitende Silizium die Temperatur, bei der sich der Widerstand ändert, insbesondere abnimmt, beeinflusst wird. In besonders vorteilhafter Weise kann der Wert bzw. die Größe des Widerstandes über das Dotierprofil und die Geometrie beliebig verändert werden. Somit ist ein vorgebbarer gewünschter Widerstand und sogar ein bestimmter temperaturabhängiger Widerstandsverlauf einstellbar.

Weitere Vorteile der Erfindung werden durch die in den Unteransprüchen angegebenen Maßnahmen erzielt. Dabei wird das erfindungsgemäße Bauelement in besonders vorteilhafter Weise so ausgestaltet, dass es den Charakter eines Schalters annimmt, wobei sich dann der Widerstand des Halbleiterbauelements bei Erreichen der beispielsweise temperaturabhängigen Einschaltbedingung über die Zeit sehr rasch ändert. Bei sonst festgehaltenen Bedingungen hängt diese Zeit bis zum Einschalten von den Montagebedingungen ab, insbesondere von den Wärmekapazitäten und Wärmewiderständen. Ein solches Temperatur- und/oder Zeitverhalten für den Wert eines Widerstandes wird bei bekannten Bauelementen in ähnlicher Weise von einem sogenannten DIAC erzielt. Ein solcher DIAC hat aber eine symmetrische Kennlinie und schaltet bei Überschreitung einer bestimmten Spannung, während er unter dieser Spannung sperrt und damit nicht das eigentliche Verhalten eines Widerstandes mit endlichem Widerstandswert zeigt.

Die erfindungsgemäßen Verfahren 15 bis 18 zur Herstellung von Halbleiterbauelementen mit den Merkmalen der Ansprüche 1 bis 15 ermöglichen eine zuverlässige und störungsfreie Herstellung der Halbleiterbauelemente mittels in der Halbleitertechnik bekannter Maßnahmen bzw. Technologien.

### Zeichnung

Ein Ausführungsbeispiel der Erfindung ist in der Zeichnung dargestellt und wird in der nachfolgenden Beschreibung näher erläutert. Im Einzelnen zeigt:
- Figur 1: einen schematischen Querschnitt durch ein erfindungsgemäßes Halbleiterbauelement und
- Figur 2: eine Kennlinie, die den Zusammenhang zwischen Strom und Spannung bei verschiedenen Temperaturen des Bauelements angibt.

### Beschreibung

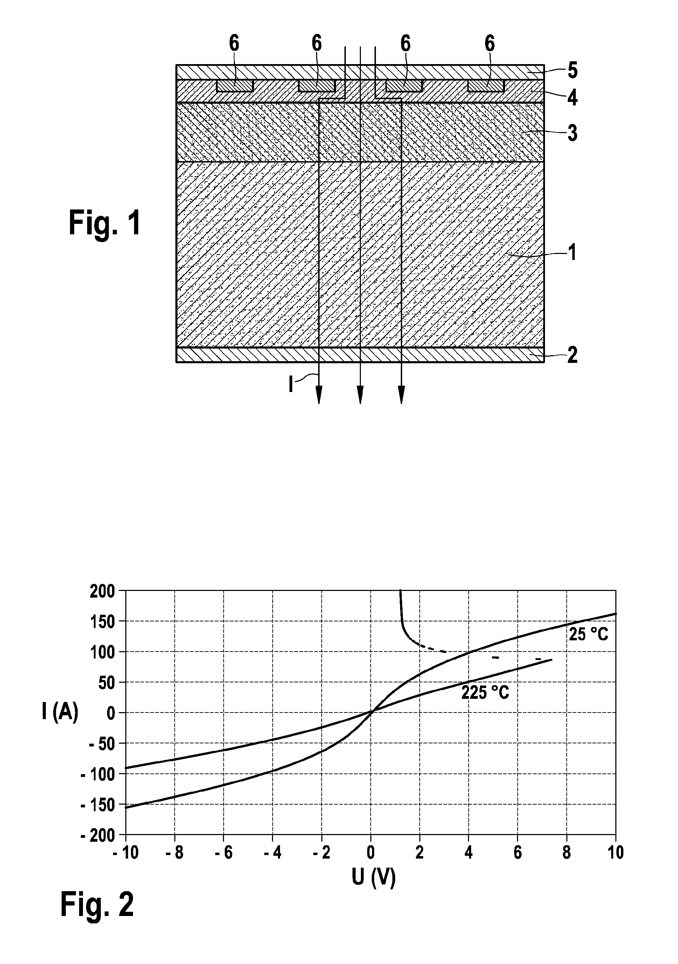

In Figur 1 ist ein Ausführungsbeispiel eines erfindungsgemäßen Halbleiterbauelements im Querschnitt schematisch dargestellt. Dabei besteht das Halbleiterelement aus einem hochdotierten Substrat 1 mit metallischem Anschluss 2 an seiner einen, in der Darstellung nach Figur 1 unteren Hauptoberfläche. Über dem hochdotierten Substrat 1 ist eine auf der oberen Hauptoberfläche ganzflächig aufgebrachte schwächer dotierte Zone 3 gleichen Leitfähigkeitstyps aufgebracht. Eine weitere ganzflächig eingebrachte Zone 4 gleichen Leitfähigkeitstyps aber höherer Dotierung schließt sich an die Zone 3 an. Ein ebenfalls ganzflächig aufgebrachter zweiter metallischer Anschluss 5 begrenzt das Halbleiterbauelement.

In der höher dotierten Zone 4, sind in Teilbereichen Gebiete 6 umgekehrten Leitfähigkeitstyps eingebracht. Der an der oberen (in der Darstellung nach Figur 1) Hauptoberfläche des Halbleiterkörpers zwischen den Zonen 4 und 6 entstehende pn-Übergang wird durch die Metallisierung 5 kurzgeschlossen.

Das hochdotierte Substrat 1 besteht beispielsweise aus antimon- oder vorzugsweise arsendotiertem Silizium. Die Zone 3 besteht beispielsweise aus epitaktisch abgeschiedenem phosphordotiertem Silizium. Die Zone 4 weist erfindungsgemäß ein gestuftes Störstellenprofil auf, das beispielsweise durch zwei Ionen-Implantationen mit unterschiedlicher Ionenart und Energie erzeugt wird. Vorteilhaft ist eine flache Arsen-Implantation mit niedriger Energie und eine tiefere Phospor-Implantation mit höherer Energie.

Die Zone 6 wird beispielsweise mittels Fotolithografie auf flecken- oder streifenförmige Gebiete beschränkt und mittels Bor-Implantation definiert. Nach den Implantationen wird ein Temperschritt durchgeführt, wobei nach diesem Temperschritt die Eindringtiefe der Bor-Inonen in Zone 6 zwischen der der Arsen- und der Phosphor-Ionen in Zone 4 liegt. Die beiden metallischen Anschlüsse 2 und 5 sind beim Ausführungsbeispiels ganzflächig auf Ober- und Unterseite des Wafers aufgebracht und lötfähig, damit das Halbleiterbauelement in einen Stromkreis eingebracht werden kann, wobei dies so erfolgt, dass jeweils an der oberen und unteren Schicht ein Stromleiter angelötet wird. Nach Anlegen einer Spannung fließt dann ein Strom I, dessen Verteilung bzw. Aufteilung in einzelne Komponenten im Halbleiterbauelement durch die drei Pfeile dargestellt ist.

Prinzipiell könnten die metallischen Anschlüsse 2 und 5 auch so ausgestaltet sein, dass sie nur vorgebbare Teilbereiche abdecken. Eine weitere Möglichkeit besteht darin, das Halbleiterbauelement bzw. das Halbleiterchips ausgehend von einem Wafer, beispielsweise einem Siliziumwafer als Substrat herzustellen und nach dem Zersägen des Wafers das erhaltene Halbleiterbauelement bzw. das Halbleiterchip in ein Gehäuse zu montieren, das oberhalb und unterhalb der Chips eine ausreichende thermische Masse, beispielsweise in Form von Kupfer enthält.

Die Herstellung des Halbleiterelements erfolgt beispielsweise in folgenden Schritten:
Das hochdotierte Substrat 1, das ein handelsübliches Arsen-Substrat ist (n-leitendes Silizium mit Arsen-Dotierung), wird mit einem Epitaxieverfahren behandelt, wobei die Schicht 3 aufgebracht wird. Die Epitaxie bestimmt im Wesentlichen den Wert des Widerstandes des Halbleiterbauelements. Eine Schicht von 10 Ohmcm bei einer Dicke von 5µ gibt unter Berücksichtigung von Ausdiffusion des Substrats und der Schicht 4 bei einer Chipgröße von 16 mm² einen Widerstand von ca. 10 Milliohm, bei einer Temperatur von 25°C und kleinem Strom.

Nach der Epitaxie der Schicht 3 wird die Zone 4 hergestellt. Dabei wird eine ganzflächige Implantation von Arsen und Phosphor zur Darstellung der Zone 4 durchgeführt, und wird das gestufte Störstellenprofil erzeugt. Im nächsten Schritt wird Fotolack aufgebracht und eine Fotomaske hergestellt. Im nächsten Schritt wird belichtet bei aufgebrachter Fotomaske zur Erzeugung der p-Inseln 6 in der Zone 4 und der Fotolack entwickelt.

In einem weitern Schritt wird Bor implantiert, wodurch sich die p-Bereiche ergeben. Nach einem Temperschritt mit einer vorgebbaren Temperaturbehandlung wird auf Vorder- und Rückseite des Chips mittels Sputtern eine Metallisierung aufgebracht, wodurch die Metallschichten 2 und 5 entstehen.

Die Funktionsweise des Halbleiterbauteils lässt sich wie folgt erklären:
Nach Einbringen des Halbleiterbauteils in einen Stromleiter und Anlegen einer Spannung an den Stromleiter fließt ein Strom I, dessen Verlauf durch die Pfeile dargestellt ist, durch das Halbleiterbauelement. Der Strom fließt zwischen den p-dotierten Bereichen in der Schicht 4 zumindest teilweise parallel zur Oberfläche des Halbleiterbauelements. Die Komponente des Stroms parallel zur Oberfläche verursacht dabei einen Spannungsabfall, der - abhängig von Strom, Temperatur, Dotierprofil und Geometrie der p-Inseln - unterhalb der Zone 6 zum Aufsteuern des pn-Übergangs zwischen den Schichten 4 und 6 führt und damit durch Löcherinjektion zu einer Reduktion des Wertes des Widerstandes der Zone 3 führt.

Die Zeit bis zum Erreichen der für den Schaltvorgang nötigen Temperatur hängt wiederum von den thermischen Zeitkonstanten des montierten Bauelements ab. Die Zeit wird umso größer, je mehr geeignetes Metall, bspw. Kupfer verwendet wird, wobei dieses Metall möglichst beidseitig eingesetzt werden soll, und je kleiner der Wärmewiderstand der Lötung zwischen dem Chip und dem Kupfer ist.

In Figur 2 ist eine Kennlinie für das Halbleiterbauelement dargestellt, bei der der Strom in Ampere über der Spannung in Volt aufgetragen ist, dabei ist der Verlauf für zwei unterschiedliche Temperaturen, nämlich 25°C und 225°C dargestellt. Wie der Figur 2 zu entnehmen ist, ist die Kennlinie bei 25°C symmetrisch zum Nullpunkt, also symmetrisch zu U=0 und I=0. Die S-Form ist mit der Abnahme der Ladungsträger-Beweglichkeit bei hohen Feldstärken zu erklären sowie damit, dass die Temperatur bei der Kennlinienmessung nicht konstant bleibt. Bei 225°C weist die Kennlinie über einen weiten Bereich einen nahezu linearen Verlauf auf und ändert seine Charakteristik oberhalb einer bestimmten Spannung sprunghaft. Abhängig von Temperatur und Strom schaltet das Bauelement also in einen Zustand mit niedrigem Widerstand und dem Charakter einer Diodenkennlinie.

Das erfindungsgemäße Halbleiterbauelement ist besonders dazu geeignet, als Schalter mit bestimmter Temperaturcharakteristik eingesetzt zu werden. Dabei kann bei Erreichen einer bestimmten Bedingung, beispielsweise bei Erreichen einer bestimmten Temperatur eine so starke Änderung der Eigenschaften des Bauelements eintreten, dass dies einem Schaltvorgang entspricht.

In eine Starterleitung integriert ermöglicht das Halbleiterbauelement das Auftreten von Stromspitzen beim Einschalten zu verhindern, da es bei tiefen Temperaturen hochohmig ist. Bei höheren Temperaturen, die durch den Energieumsatz im noch kalten Halbleiterbauelement verursacht werden verringert sich der Wert des Widerstandes des Halbleiterbauelements stark und dieses behindert den Strom bei den dann vorliegenden höheren Temperaturen nicht mehr.

Als thermischer Schalter eingesetzt lässt sich mit dem Halbleiterbauelement eine Anordnung ausbilden, die bei tiefen Temperaturen den Strom sperrt und bei hohen Temperaturen leitet, wobei der Umschaltpunkt bzw. der Umschaltbereich in weiten Grenzen einstellbar ist. Dabei kann der Wert bzw. die Größe des Widerstandes über das Dotierprofil und die Geometrie beliebig verändert werden. Somit ist ein vorgebbarer gewünschter Widerstand und sogar ein bestimmter temperaturabhängiger Widerstandsverlauf einstellbar. Wesentlich ist auch, dass sich der Widerstand des Halbleiterbauelements bei Erreichen der temperaturabhängigen Einschaltbedingung über die Zeit sehr rasch ändert.

## Patentansprüche

1. Halbleiterbauelement mit einem hochdotierten Substrat (1), das an seiner einen Hauptoberfläche eine Metallisierung (2) aufweist und mit seiner anderen Hauptoberfläche mit einer schwächer dotierten Zone (3), die vom gleichen Leitfähigkeitstyp ist, in Verbindung steht und einer weiteren Schicht (4) vom gleichen Leitfähigkeitstyp mit höherer Dotierung sowie einer Metallisierung (5), die die andere Hauptoberfläche des Halbleiterbauelements bildet, wobei in Teilbereiche der Zone (4) Gebiete (6) umgekehrten Leitfähigkeitstyps eingebracht sind, wobei der an der zweiten Hauptoberfläche des Halbleiterkörpers zwischen den Zonen (4) und den Gebieten umgekehrten Leitfähigkeitstyps (6) entstehende pn-Übergang durch die Metallisierung (5) kurzgeschlossen ist., **dadurch gekennzeichnet, dass** die Zone (4) ein gestuftes Störstellenprofil aufweist.

2. Halbleiterbauelement nach Anspruch 1, **dadurch gekennzeichnet, dass** das Substrat (1) aus antimon- oder arsendotiertem Silizium besteht und damit n leitend ist.

3. Halbleiterbauelement nach Anspruch 2, **dadurch gekennzeichnet, dass** die Zone (3) aus epitaktisch abgeschiedenem phosphordotiertem Silizium besteht und damit ebenfalls n leitend ist.

4. Halbleiterbauelement nach einem der vorhergehenden Ansprüche, **dadurch gekennzeichnet, dass** die Zone (4) unterschiedliche Ionen, insbesondere As-Ionen und P-Ionen aufweist, die durch Ionen-Implantation mit unterschiedlicher Ionenart und Energie in die Zone (4) eingebracht sind.

5. Halbleiterbauelement nach einem der vorhergehenden Ansprüche, **dadurch gekennzeichnet, dass** einer oder beide metallische Anschlüsse (2), (5) ganzflächig auf den Hauptbegrenzungsflächen des Halbleitersubstrats aufgebracht sind.

6. Halbleiterbauelement nach Anspruch 5, **dadurch gekennzeichnet, dass** die metallischen Anschlüsse lötfähig sind.

7. Halbleiterbauelement nach einem der vorhergehenden Ansprüche, **dadurch gekennzeichnet, dass** sich der Halbleiterchip bzw. das Substrat mit den verschiedenen Bereichen in einem Gehäuse befindet, wobei beidseitig des Chips eine thermisch und elektrisch wirksame Masse insbesondere in Form von Kupfer vorhanden ist.

8. Halbleiterbauelement nach einem der vorhergehenden Ansprüche, **dadurch gekennzeichnet, dass** sein Widerstand temperaturabhängig ist und in einem einstellbaren Temperaturbereich starke Änderungen aufweist.

9. Halbleiterbauelement nach einem der vorhergehenden Ansprüche, **dadurch gekennzeichnet, dass** sein temperaturabhängiger Widerstand mittels Wahl des Dotierprofils und/oder mittels Wahl der Geometrie des Halbleiterbauelements einstellbar ist.

10. Halbleiterbauelement nach Anspruch 8 oder 9, **dadurch gekennzeichnet, dass** der Temperaturbereich, in dem der Widerstand starke Änderungen aufweist, sich mittels Wahl des Dotierprofils und/oder mittels Wahl der Geometrie des Halbleiterbauelements einstellen lässt.

11. Halbleiterbauelement nach einem der vorhergehenden Ansprüche, **dadurch gekennzeichnet, dass** es als temperaturabhängiger Schalter eingesetzt wird.

12. Halbleiterbauelement nach Anspruch 11, **dadurch gekennzeichnet, dass** die Schalttemperatur mittels Wahl des Dotierprofils und/oder mittels Wahl der Geometrie des Halbleiterbauelements einstellbar ist, wobei die Schalttemperatur die Temperatur ist, bei der eine große Änderung des Widerstandes auftritt.

13. Halbleiterbauelement nach einem der vorhergehenden Ansprüche, **dadurch gekennzeichnet, dass** die Zeit bis zum Erreichen der für den Schaltvorgang nötigen Schalttemperatur abhängig von den thermischen Zeitkonstanten des Bauelements ist.

14. Halbleiterbauelement nach einem der vorhergehenden Ansprüche, **dadurch gekennzeichnet, dass** es als temperaturabhängige Strombegrenzung eingesetzt wird.

15. Verfahren zur Herstellung eines Halbleiterbauelements nach einem der vorhergehenden Ansprüche, **dadurch gekennzeichnet, dass** auf ein hochdotiertes Substrat (1), insbesondere aus antimon- oder arsendotiertem Silizium eine epitaktisch abgeschiedene schwächer dotierte Zone (3) vom gleichen Leitfähigkeitstyp aufgebracht wird, dass mittels ganzflächiger Implantation von Arsen und Phosphor eine Zone (4) vom gleichen Leitfähigkeitstyp gebildet wird, dass in Teilbereiche der Zone (4) Gebiete (6) umgekehrten Leitfähigkeitstyps eingebracht werden und dass beide Hauptoberflächen mit jeweils einer Metallisierung (2), (5) versehen werden, wobei die Metallisierung (5) den zwischen den Zonen (4) und den Gebieten umgegekehrten Leitfähigkeitstyps (6) entstehende pn-Übergang kurzschließt, **dadurch gekennzeichnet, dass** in der Zone (4) ein gestuftes Störstellenprofil erzeugt wird.

16. Verfahren zur Herstellung eines Halbleiterbauelements nach Anspruch 15, **dadurch gekennzeichnet, dass** das gestufte Störstellenprofil durch zwei Ionen-Implantationen mit unterschiedlicher Ionenart und unterschiedlicher Energie erzeugt wird, insbesondere als flache Arsen-Implementation mit niedriger Energie und als tiefe Phosphor-Implantation mit höherer Energie.

17. Verfahren nach Anspruch 16, **dadurch gekennzeichnet, dass** nach der Ionen-Implantation ein Temperschritt durchgeführt und dass zumindest nach diesem Temperschritt die Eindringtiefe der Bor-Ionen in den Gebieten umgekehrten Leitfähigkeitstyps (6) zwischen der Arsen- und der Phosphor-Ionen in Zone (4) liegt.

18. Verfahren nach einem der vorhergehenden Ansprüche, **dadurch gekennzeichnet, dass** das Substrat (1) ein Halbleiterchip ist, der nach Fertigstellung und Zersägen in einem Gehäuse montiert wird, wobei das Gehäuse oberhalb und unterhalb des Chips eine ausreichende thermische Masse, insbesondere aus Kupfer enthält.

## Claims

1. Semiconductor component comprising a highly doped substrate (1), which has at one main surface thereof a metallization (2) and is connected by its other main surface to a more weakly doped zone (3), which is of the same conductivity type, and comprising a further layer (4) of the same conductivity type with higher doping, and also comprising a metallization (5), which forms the other main surface of the semiconductor component, where regions (6) of opposite conductivity type are introduced into partial areas of the zone (4), wherein the pn junction that arises at the second main surface of the semiconductor component between the zones (4) and the regions of opposite conductivity type (6) is short-circuited by the metallization (5), **characterized in that** the zone (4) has a stepped defect profile.

2. Semiconductor component according to Claim 1, **characterized in that** the substrate (1) consists of antimony- or arsenic-doped silicon and is thus n-conducting.

3. Semiconductor component according to Claim 2, **characterized in that** the zone (3) consists of epitaxially deposited phosphorus-doped silicon and is thus likewise n-conducting.

4. Semiconductor component according to any of the preceding claims, **characterized in that** the zone (4) has different ions, in particular As ions and P ions, which are introduced into the zone (4) by ion implantation with different ion type and energy.

5. Semiconductor component according to any of the preceding claims, **characterized in that** one or both metallic terminals (2), (5) are applied over the whole area on the main boundary surfaces of the semiconductor substrate.

6. Semiconductor component according to Claim 5, **characterized in that** the metallic terminals are solderable.

7. Semiconductor component according to any of the preceding claims, **characterized in that** the semiconductor chip or the substrate with the various regions is situated in a housing, wherein a thermally and electrically effective mass in particular in the form of copper is present on both sides of the chip.

8. Semiconductor component according to any of the preceding claims, **characterized in that** its resistance is temperature-dependent and has great changes in an adjustable temperature range.

9. Semiconductor component according to any of the preceding claims, **characterized in that** its temperature-dependent resistance is adjustable by means of the choice of the doping profile and/or by means of the choice of the geometry of the semiconductor component.

10. Semiconductor component according to Claim 8 or 9, **characterized in that** the temperature range in which the resistance has great changes can be adjusted by means of the choice of the doping profile and/or by means of the choice of the geometry of the semiconductor component.

11. Semiconductor component according to any of the preceding claims, **characterized in that** it is used as a temperature-dependent switch.

12. Semiconductor component according to Claim 11, **characterized in that** the switching temperature is adjustable by means of the choice of the doping profile and/or by means of the choice of the geometry of the semiconductor component, wherein the switching temperature is the temperature at which a large change in the resistance occurs.

13. Semiconductor component according to any of the preceding claims, **characterized in that** the time until the switching temperature necessary for the switching process is attained is dependent on the thermal time constants of the component.

14. Semiconductor component according to any of the preceding claims, **characterized in that** it is used as temperature-dependent current limiting.

15. Method for producing a semiconductor component according to any of the preceding claims, **characterized in that** an epitaxially deposited more weakly doped zone (3) of the same conductivity type is applied to a highly doped substrate (1), in particular composed of antimony- or arsenic-doped silicon, **in that** a zone (4) of the same conductivity type is formed by means of whole-area implantation of arsenic and phosphorus, **in that** regions (6) of opposite conductivity type are introduced into partial areas of the zone (4), and **in that** both main surfaces are provided with a respective metallization (2), (5), wherein the metallization (5) short-circuits the pn junction that arises between the zones (4) and the regions of opposite conductivity type (6), **characterized in that** a stepped defect profile is produced in the zone (4).

16. Method for producing a semiconductor component according to Claim 15, **characterized in that** the stepped defect profile is produced by two ion implantations with different ion type and different energy, in particular as shallow arsenic implantation with low energy and as deep phosphorus implantation with higher energy.

17. Method according to Claim 16, **characterized in that** a heat treatment step is carried out after the ion implantation, and **in that** at least after said heat treatment step the penetration depth of the boron ions in the regions of opposite conductivity type (6) lies between the arsenic and phosphorus ions in zone (4).

18. Method according to any of the preceding claims, **characterized in that** the substrate (1) is a semiconductor chip which is mounted in a housing after completion and sawing, wherein the housing contains a sufficient thermal mass, in particular composed of copper, above and below the chip.

## Revendications

1. Composant semi-conducteur doté d'un substrat (1) fortement dopé présentant une métallisation (2) sur l'une de ses surfaces principales et relié par son autre surface principale à une zone (3) plus faiblement dopée de même type de conductivité, et une autre couche (4) de même type de conductivité à dopage plus élevé ainsi qu'une métallisation (5) qui forme l'autre surface principale du composant semi-conducteur,
des domaines (6) d'un type de conductivité opposé étant formés dans des parties de la zone (4),
la transition pn réalisée sur la deuxième surface principale du corps semi-conducteur entre les zones (4) et les domaines (6) de conductivité de type opposé étant mise en court-circuit par la métallisation (5), **caractérisé en ce que**
la zone (4) présente un profil étagé d'emplacements perturbés.

2. Composant semi-conducteur selon la revendication 1, **caractérisé en ce que** le substrat (1) est constitué de silicium dopé à l'antimoine ou à l'arsenic et est donc à conductivité n.

3. Composant semi-conducteur selon la revendication 2, **caractérisé en ce que** la zone (3) est formée de silicium dopé au phosphore et déposé par épitaxie et est donc également de conductivité n.

4. Composant semi-conducteur selon l'une des revendications précédentes, **caractérisé en ce que** la zone (4) présente des ions différents, en particulier des ions d'As et des ions de P qui sont apportés dans la zone (4) par implantation d'ions de types différents et à différentes énergies.

5. Composant semi-conducteur selon l'une des revendications précédentes, **caractérisé en ce qu'**une ou les deux bornes métalliques de raccordement (2), (5) sont formées sur toute la surface de frontière principale du substrat semi-conducteur.

6. Composant semi-conducteur selon la revendication 5, **caractérisé en ce que** les bornes métalliques de raccordement peuvent être brasées.

7. Composant semi-conducteur selon l'une des revendications précédentes, **caractérisé en ce que** la puce semi-conductrice ou le substrat présentant les différentes parties sont placés dans un boîtier, une masse à action thermique et électrique, qui présente en particulier la forme de cuivre, étant prévue des deux côtés de la puce.

8. Composant semi-conducteur selon l'une des revendications précédentes, **caractérisé en ce que** sa résistance dépend de la température et présente de fortes modifications dans une plage de température réglable.

9. Composant semi-conducteur selon l'une des revendications précédentes, **caractérisé en ce que** sa résistance dépendant de la température peut être ajustée par sélection du profil de dopage et/ou par sélection de la géométrie du composant semi-conducteur.

10. Composant semi-conducteur selon les revendications 8 ou 9, **caractérisé en ce que** la plage de température dans laquelle la résistance présente de fortes modifications peut être établie par sélection du profil de dopage et/ou par sélection de la géométrie du composant semi-conducteur.

11. Composant semi-conducteur selon l'une des revendications précédentes, **caractérisé en ce qu'**il est utilisé comme commutateur dépendant de la température.

12. Composant semi-conducteur selon la revendication 11, **caractérisé en ce que** la température de commutation peut être ajustée par sélection du profil de dopage et/ou par sélection de la géométrie du composant semi-conducteur, la température de commutation étant la température à laquelle une grande modification de résistance a lieu.

13. Composant semi-conducteur selon l'une des revendications précédentes, **caractérisé en ce que** la durée nécessaire pour atteindre la température de commutation nécessaire pour l'opération de commutation dépend des constantes thermiques du composant.

14. Composant semi-conducteur selon l'une des revendications précédentes, **caractérisé en ce qu'**il est utilisé comme limiteur de courant dépendant de la température.

15. Procédé de fabrication d'un composant semi-conducteur selon l'une des revendications précédentes, dans lequel
une zone (3) faiblement dopée est appliquée par dépôt épitaxique sur un substrat (1) plus fortement dopé et de même type de conductivité, en particulier en silicium dopé à l'antimoine ou à l'arsenic,
une zone (4) de même type de conductivité est formée par implantation d'arsenic et de phosphore sur toute la surface,
des domaines (6) d'un type de conductivité opposé sont formés dans des parties de la zone (4) et
les deux surfaces principales sont chacune dotée d'une métallisation (2), (5), la métallisation (5) mettant en court-circuit la transition pn formée entre les zones (4) et les domaines (6) d'un type de conductivité opposé,
**caractérisé en ce que**
un profil étagé d'emplacements perturbés est formé dans la zone (4).

16. Procédé de fabrication d'un composant semi-conducteur selon la revendication 15, **caractérisé en ce que** le profil étagé d'emplacements perturbés est formé par deux implantations d'ions de types différents et à des énergies différentes, en particulier comme implantations en surface d'arsenic à plus basse énergie qu'une implantation de phosphore profonde à plus haute énergie.

17. Procédé selon la revendication 16, **caractérisé en ce qu'**après l'implantation d'ions, une étape thermique est réalisée et **en ce qu'**au moins après cette étape thermique, la profondeur de pénétration des ions de bore dans les domaines (6) d'un type de conductivité opposé est située entre les ions d'arsenic et les ions de phosphore dans la zone (4).

18. Procédé selon l'une des revendications précédentes, **caractérisé en ce que** le substrat (1) est une puce semi-conductrice qui, après fabrication et sciage, est montée dans un boîtier, le boîtier contenant au-dessus et en dessous de la puce une masse suffisamment thermique, en particulier en cuivre.
